# EUROPEAN PATENT SPECIFICATION

(11) **EP 1 837 992 B1**
(45) Date of publication and mention of the grant of the patent: **23.02.2011**
(21) Application number: 06114806.0
(22) Date of filing: 31.05.2006
(51) Int. Cl.: H03K 17/08

(54) **Digital output module overload protection**
Überlastungsschutz für ein digitales Ausgangsmodul
Protection contre la surcharge du module de sortie numérique

(30) Priority: 24.03.2006 US 785537 P
(43) Date of publication of application: 26.09.2007
(73) Proprietor: ICS Triplex Technology Limited, Heybridge Maldon, Essex CM9 4LA (GB)
(72) Inventor: Meagher, Thomas, Bruce, Houston, TX 77084 (US); Murphy, Kenneth, John, Henderson, NV 89012 (US)
(74) Representative: Simons, Alison

(56) References cited:
- EP-A- 0 789 458
- US-A- 5 867 014
- US-A- 5 896 263
- US-A- 6 125 024
- US-B1- 6 400 163

## Description

### BACKGROUND

### a. Field of the Invention

This invention relates to fault detection in electrical circuits, in particular it relates to overload protection in a switch circuit for digital output modules.

In safety control systems, fault tolerance is of utmost importance. Fault tolerance is the ability to continue functioning in the event of one or more failures within the system.

Fault tolerance may be achieved by a number of different techniques, each with its specific advantages and disadvantages. One example of fault tolerance is known as Hardware Implemented Fault Tolerance (HIFT). HIFT means that the system relies on robust hardware circuits (as opposed to complex software algorithms) to perform the fault detection and redundancy management functions. A significant advantage HIFT has over software-implemented fault tolerance is that HIFT eliminates the overhead for communications between processors, leaving more time for controlling the process. This makes HIFT systems significantly faster and more dependable than systems using software-implemented fault tolerance.

An example of a HIFT system is a system which provides redundancy, in particular Triple Modular Redundancy (TMR). Using TMR, critical circuits are triplicated and perform identical functions simultaneously and independently. The data output from each of the three circuits is voted in a majority-voting circuit, before affecting the system's outputs. If one of the triplicated circuits fails, its data output is ignored. However, the system continues to output to the process the value (voltage, current level, or discrete output state) that agrees with the majority of the functional circuits. TMR provides continuous, predictable operation.

HIFT and TMR provides for automatic fault recovery with no disruption to system operation and ensures minimal fault detection periods.

Another approach to fault tolerance is the use of hot-standby modules. This approach provides a level of fault tolerance whereby the standby module maintains system operation in the event of module failure. With this approach there may be some disruption to system operation during the changeover period if the modules are not themselves fault-tolerant.

Fault tolerant systems ideally create a Fault Containment Region (FCR) to ensure that a fault within the FCR boundary does not propagate to the remainder of the system. This enables multiple faults to co-exist on different parts of a system without affecting operation.

Fault tolerant systems generally employ dedicated hardware and software test and diagnostic regimes that provide very fast fault recognition and response times to provide a safer system.

Commonly, it is possible to repair faults without interrupting system operation (known as hot replacement). For example active and standby module may operate in parallel so that if an active module becomes faulty there is an automatic change over to a standby module.

Safety control systems are generally designed to be 'fail-operational/fail-safe'. Fail operational means that when a failure occurs, the system continues to operate: it is in a fail-operational state. The system should continue to operate in this state until the failed module is replaced and the system is returned to a fully operational state.

An example of fail safe operation occurs, for example if, in a TMR system, a failed module is not replaced before a second failure in a parallel circuit occurs, the second failure should cause the TMR system to shut down to a fail-safe state.

Typical safety control applications include emergency and safety shutdown systems, process control, reactor control, wellhead control, turbine and compressor control, fire and gas detection and abatement, and are applicable to many industries including oil and gas production and refining, chemical production and processing, power generation, paper and textile mills and sewage treatment plants.

European Patent Application No EP 0 789 458 describes a circuit with overload current protection for power transistors which incorporates a circuit for limitation of the maximum current delivered by a power trasnsister.

United States Patent No 6,125,024 describes solod sate power controller for switching power on and off to an electrical load which also serves as a circuit protection device protecting from damage due to current overload.

United States Patent No 6,400,163 describes a circuit arrangement for controlling a load and current flowing through the load during turn-on intervals.

### SUMMARY OF THE INVENTION

According to the invention there is provided a switch for a fault tolerant digital output module comprising: an output transistor pair for enabling and disabling an alternating output current; and a current limiter for clamping the output current to a predetermined maximum value and
an overvoltage monitor (6261,2121) for monitoring the voltage across the output transistor pair:
characterised in that said overvoltage monitor sets an overvoltage signal in the event that the monitored voltage exceeds a predetermined maximum voltage the switch further comprises a diagnostic monitor (6291) arranged in operation to sample the overvoltage signal at overvoltage sampling intervals and in the event that that the output transistor pair is enabling the output alternating current and the overvoltage signal is set for more than a predetermined number of overvoltage samples an overload condition is detected.

Preferably, the current limiter comprises a pair of current sense transistors.

In a preferred embodiment the overvoltage sampling interval is substantially equal to 60µs, the predetermined maximum voltage value is substantially between 10V and 35V and the predetermined number of voltage samples is equal to 1, 2, 3 or 4.

Preferably, the switch further comprises a current monitor for monitoring the current through the output transistor pair and which is arranged in operation to sample the current at current sampling intervals and in the event that the current exceeds a predetermined absolute maximum current value for more than a predetermined number of current samples an overload condition is detected.

In a preferred embodiment, the current sampling interval is substantially equal to 240µs and the predetermined number of current samples is in the range 1-4.

Preferably, the switch further comprises an average current monitor for monitoring the average current though the output transistor pairs and which is arranged in operation to sample the average current at average current sampling intervals and in the event that the average current exceeds an average current predetermined threshold for more than a predetermined number of AC cycles an overload condition is detected.

In a preferred embodiment, the average current sampling interval is substantially equal to 300ms and the predetermined number of AC cycles is 3.

### BRIEF DESCRIPTION OF THE DRAWINGS

The invention will now be described, by way of example only, with reference to the accompanying drawings in which:
Figure 1 illustrates schematically a fault tolerant architecture;
Figure 2 is a block diagram of a fault tolerant output module;
Figure 3 is a block diagram illustrating a fault tolerant AC digital output module switch section; and
Figure 4 is a circuit diagram of a fault tolerant AC digital output module switch section.

### DETAILED DESCRIPTION

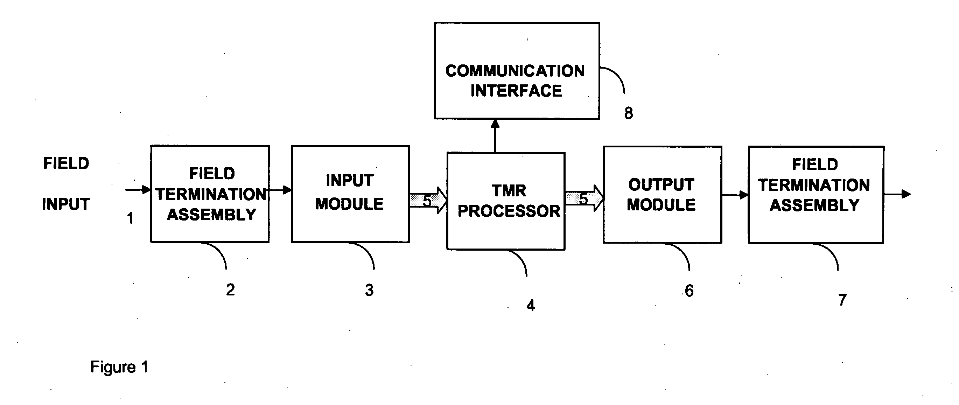

Referring now to Figure 1, signals 1 from an input field device (not shown) are connected to the system via an input Field Termination Assembly (FTA) 2. An input 3 module receives, buffers and carries out any necessary conversion of the input data from the field device. The input data is then transmitted over a triplicated Inter-Module Bus (IMB) 5 to a TMR processor 4. Triplicated microprocessors of the TMR processor receive the input data from each channel of the IMB 5 and carry out a majority vote of the data. During data processing, each of the three processors compares and majority votes its input data against that of the other two processors. The processors synchronously execute the application program, and the derived output data is transmitted back to the IMB. An output module 6 receives, majority votes, and carries out any necessary conversion of the output data from the TMR processor 4. The output circuits are then driven by the majority-voted command. The output signals are connected to a field device (not shown) via an output FTA 7. A communications interface 8 provides facilities to allow systems to be networked using peer to peer communications links, the collection of Sequence of Events (SOE) data, and connection to other systems.

If an internal circuit in the system fails, it is simply voted out. Comprehensive distributed voting both out-votes failures, preventing them from being propagated into the process, and simplifies the process of identifying where faults have occurred.

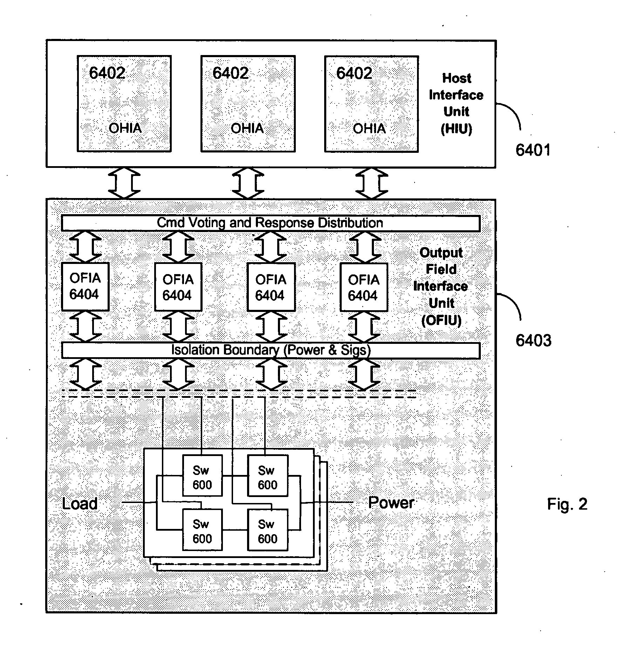

Figure 2 illustrates an output module 6 comprising a host interface unit 6401 which provides fault-tolerant communications, control, and processing facilities for the module. Output functions of the host interface unit 6401 are contained in replicated output host interface units 6402 and related DSP firmware. The output host interface units 6402 provide communication facilities to and from an output field interface unit 6403.

The output field interface unit 6403 comprises replicated output field interface modules 6404 which are galvanically isolated from replicated output switches 600 connected in a series/parallel configuration as shown.

For safety systems it is beneficial for output modules driving alternating current loads to protect the drive circuitry from damage due to external short circuit faults, as well as from less extreme load problems that may cause long-term overheating of the output drivers if not recognised. The method of protection must be balanced against the requirement to provide as much current to the load as is safely possible.

In the preferred embodiment of the invention, there are four layers of protection to prevent overload damage to the output module, while handling turn-on current surges and tolerating brief overloads.

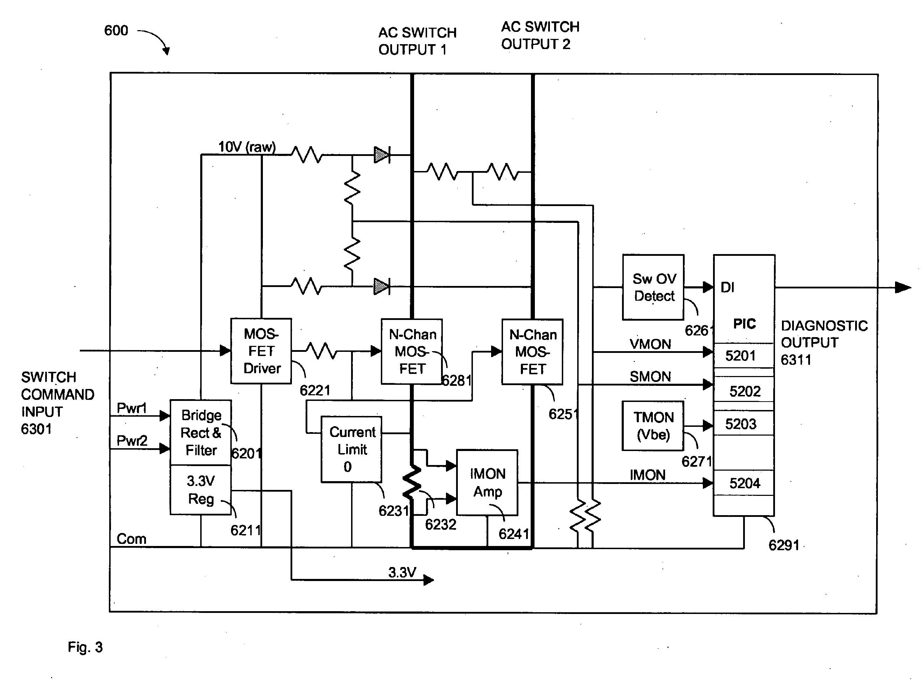

Figure 3 illustrates an output switch 600 according to a preferred embodiment of the invention. A binary input signal 6301 received from the output field interface module 6404 indicates whether the AC switch output is to be enabled or disabled.

A driver 6221 receives the input signal and drives two back-to-back FET output transistors 6281, 6251 in dependence upon the received signal 6301.

A transformer isolated high frequency AC input power signal differential pair (Pwr1 and Pwr2) are rectified and regulated by a bridge rectifier and filter 6201 and a voltage regulator 6211 to generate isolated 10V and 3.3V power supplies for various components.

A first level of overload protection is implemented in hardware directly in the output transistor control circuit. Each gate of the FET output transistors 6281, 6251 is clamped with a current sense NPN transistor pair 6231.

This current limiting transistor pair 6231 provides a virtually instantaneous current limit function to approximately 10A to 40A, depending upon the desired output current range of the implementation.

The voltage across the FET output transistors 6281, 6251 is measured by the signal VMON and the current through the FET output transistors 6281, 6251 is measured using the signal IMON which measures the current though a current sense resistor 6232.

A second level of overload protection is provided by monitoring the voltage across the output transistors at a relatively high sample rate, in the preferred embodiment every 60µs, and sending a signal to a diagnostic monitor 6291. The monitoring is done in hardware by a switch overvoltage detect transistor 6261. When the voltage across R2121 (Figure 3) ie VMON is great enough to turn on the transistor, then the result is that the signal that is sent to the output field interface module 6040 indicates excessive voltage across the switch.

In the preferred embodiment this signal is asserted if the voltage exceeds between 10V to 35V, depending upon the output current rating of the switch. If the output field interface module 6040 is commanding binary input signal 6301 such that the output is enabled, and if the voltage exceeds the predetermined maximum voltage value for more than a predetermined number of samples (in the range of 1-4 in the preferred embodiment), the output field interface module 6040 sets an overload condition and sends it via the binary input signal 6301 to be reset in order to turn the FET output transistors 6281, 6251 off and thus to disable the AC output.

A third layer of protection is provided by monitoring the load current every alternating current cycle. The load current is digitized every 240 µs and transmitted to the output host interface unit 6402 via the output field interface unit 6404 as signal IMON by the diagnostic monitor 6291. If the output host interface unit 6402 detects that the load current has saturated the IMON A/D converters in either or both directions for three consecutive AC cycles, then the output field interface module 6404 is instructed to set an overload condition and cause the binary input signal 6301 to be reset in order to turn the FET output transistors 6281, 6251 off and thus to disable the AC output.

A final layer of protection involves monitoring the load current for a persistent long term average magnitude that would result in too much heat being dissipated in the output FETs, resulting in their junction temperature exceeding the maximum rating. This is performed by in the output host interface unit 6402 by sampling the IMON load current signal every 300 mSec and averaging the value in the output host interface unit 6402. If it exceeds a given predetermined maximum average value for more than 1.5 seconds, the switch is turned off as before.

There is also a temperature monitor 6271 which sends a temperature monitor signal to the output field interface module 6404 via the diagnostic monitor 6291

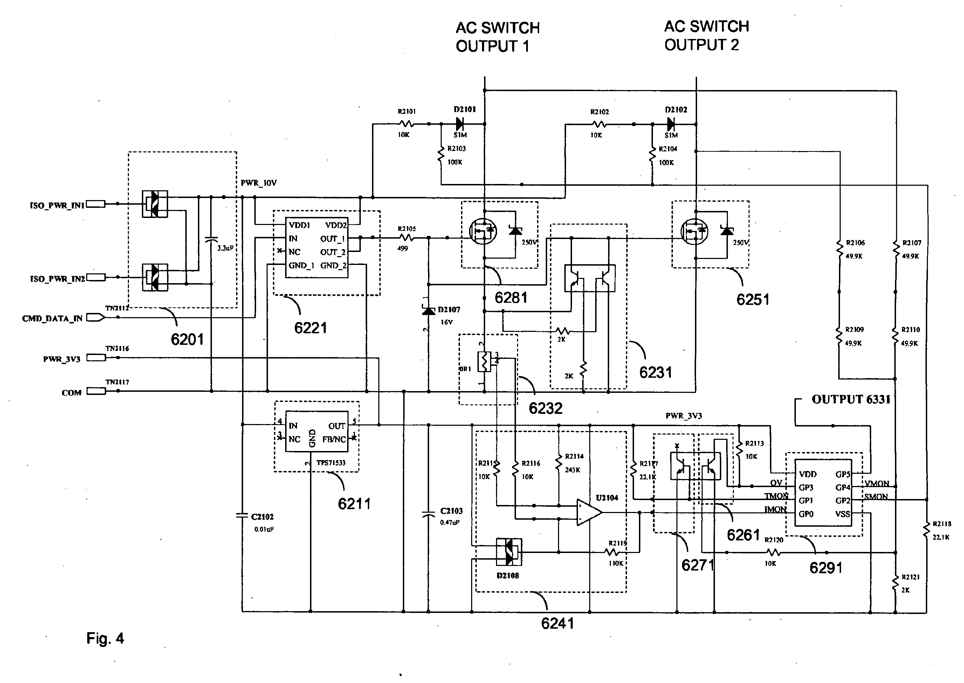

Figure 4 illustrates the internal components of the block shown in Figure 3 in more detail.

It is to be recognised that various alterations, modifications, and/or additions may be introduced into the constructions and arrangements of parts described above without departing from the scope of the present invention as defined in the following claims.

## Claims

1. A switch for a fault tolerant digital output module comprising:
an output transistor pair (6281, 6251) for enabling and disabling an alternating output current;
a current limiter (6231) for clamping the output current to a predetermined maximum value; and
an overvoltage monitor (6261,2121) for monitoring the voltage across the output transistor pair;
**characterised in that** said overvoltage monitor sets an overvoltage signal in the event that the monitored voltage exceeds a predetermined maximum voltage and the switch further comprises a diagnostic monitor (6291)arranged in operation to sample the overvoltage signal at overvoltage sampling intervals and in the event that the output transistor pair is enabling the output alternating current and the overvoltage signal is set for more than a predetermined number of overvoltage samples an overload condition is detected.

2. A switch according to claim 1, in which the current limiter (6231) comprises a pair of current sense transistors.

3. A switch according to claim 1 or claim 2, in which the overvoltage sampling interval is substantially equal to 60µs, the predetermined maximum voltage value is substantially between 10V and 35V and the predetermined number of voltage samples is equal to 1, 2, 3 or 4.

4. A switch according to any one of the preceding claims, further comprising a current monitor for monitoring the current through the output transistor pair and which is arranged in operation to sample the current at current sampling intervals and in the event that the current exceeds a predetermined absolute maximum current value for more than a predetermined number of current samples an overload condition is detected.

5. A switch according to claim 4, in which the current sampling interval is substantially equal to 240µs and the predetermined number of current samples is in the range 1-4.

6. A switch according to any one of the preceding claims further comprising an average current monitor for monitoring the average current though the output transistor pair and which is arranged in operation to sample the average current at average current sampling intervals and in the event that the average current exceeds an average current predetermined threshold for more than a predetermined number of AC cycles an overload condition is detected.

7. A switch according to claim 6, in which the average current sampling interval is substantially equal to 300ms and the predetermined number of AC cycles is 3.

## Patentansprüche

1. Schalter für ein fehlertolerantes digitales Ausgangsmodul, umfassend:
ein Ausgangstransistorpaar (6281, 6251) zum Freigeben und Sperren eines Wechselausgangsstroms;
einen Strombegrenzer (6231) zum Klemmen des Ausgangsstroms auf einen vorbestimmten Maximalwert; und
eine Überspannungs-Überwachungsvorrichtung (6261, 2121) zum Überwachen der Spannung an dem Ausgangstransistorpaar;
**dadurch gekennzeichnet, dass** die Überspannungs-Überwachungsvorrichtung ein Überspannungssignal setzt, falls die überwachte Spannung eine vorbestimmte Maximalspannung übersteigt, und der Schalter ferner eine Diagnostik-Überwachungsvorrichtung (6291) umfasst, die im Betrieb dafür ausgelegt ist, das Überspannungssignal in Überspannungsabtastintervallen abzutasten, und im Fall, dass das Ausgangstransistorpaar den Ausgangswechselstrom freigibt und das Überspannungssignal für mehr als eine vorbestimmte Anzahl von Überspannungsabtastungen gesetzt ist, ein Überlastzustand detektiert wird.

2. Schalter nach Anspruch 1, bei dem der Strombegrenzer (6231) ein Paar von Strommesstransistoren umfasst.

3. Schalter nach Anspruch 1 oder 2, wobei das Überspannungsabtastintervall im Wesentlichen gleich 60 µs ist, der vorbestimmte Maximalspannungswert im Wesentlichen zwischen 10 V und 35 V liegt und die vorbestimmte Anzahl von Spannungsabtastungen gleich 1, 2, 3 oder 4 ist.

4. Schalter nach einem der vorhergehenden Ansprüche, der ferner eine Stromüberwachungsvorrichtung zum Überwachen des Stroms durch das Ausgangstransistorpaar umfasst und im Betrieb dafür ausgelegt ist, den Strom in Stromabtastintervallen abzutasten, und wobei, falls der Strom für mehr als eine vorbestimmte Anzahl von Stromabtastungen einen vorbestimmten absoluten maximalen Stromwert überschreitet, ein Überlastzustand detektiert wird.

5. Schalter nach Anspruch 4, wobei das Stromabtastintervall im Wesentlichen gleich 240 µs ist und die vorbestimmte Anzahl von Stromabtastungen im Bereich von 1-4 liegt.

6. Schalter nach einem der vorhergehenden Ansprüche, der ferner eine Durchschnittsstrom-Überwachungsvorrichtung zum Überwachen des Durchschnittsstroms durch das Ausgangstransistorpaar umfasst, und im Betrieb dafür ausgelegt ist, den Durchschnittsstrom in Durchschnittsstrom-Abtastintervallen abzutasten, und wobei, falls der Durchschnittsstrom für mehr als eine vorbestimmte Anzahl von Wechselstromperioden eine vorbestimmte Schwelle des Durchschnittsstroms überschreitet, ein Überlastzustand detektiert wird.

7. Schalter nach Anspruch 6, bei dem das Durchschnittsstrom-Abtastintervall im Wesentlichen gleich 300 ms ist und die vorbestimmte Anzahl von Wechselstromperioden 3 ist.

## Revendications

1. Commutateur pour un module de sortie numérique insensible aux défaillances comprenant :
une paire de transistors de sortie (6281, 6251) pour permettre et empêcher un courant de sortie alternatif;
un limiteur de courant (6231) pour amortir ce courant de sortie à une valeur maximum prédéterminée ; et
un dispositif de surveillance de surtension (6261, 2121) pour surveiller la tension aux bornes de la paire de transistors de sortie ;
**caractérisé en ce que** ledit dispositif de surveillance de surtension établit un signal de surtension dans le cas où la tension surveillée dépasse une tension maximum prédéterminée et ce commutateur comprend en outre un dispositif de surveillance de diagnostic (6291) agencé, lorsqu'il fonctionne, de façon à échantillonner le signal de surtension à des intervalles d'échantillonnage de surtension et, dans le cas où la paire de transistors de sortie permet le courant alternatif de sortie et où le signal de surtension est établi pour plus qu'un nombre prédéterminé d'échantillons de surtension, une condition de surcharge est détectée.

2. Commutateur selon la revendication 1, dans lequel le limiteur de courant (6231) comprend une paire de transistors de détection de courant.

3. Commutateur selon la revendication 1 ou la revendication 2, dans lequel l'intervalle d'échantillonnage de surtension est essentiellement égal à 60 µs, la valeur de tension maximum prédéterminée est située essentiellement entre 10 V et 35 V et le nombre prédéterminé d'échantillons de tension est égal à 1, 2, 3 ou 4.

4. Commutateur selon l'une quelconque des revendications précédentes, comprenant en outre un dispositif de surveillance de courant pour surveiller le courant à travers la paire de transistors de sortie et qui est agencé, lorsqu'il fonctionne, de façon à échantillonner le courant à des intervalles d'échantillonnage de courant et, dans le cas où le courant dépasse une valeur de courant maximum absolue prédéterminée pour plus qu'un nombre prédéterminé d'échantillons de courant, une condition de surcharge est détectée.

5. Commutateur selon la revendication 4, dans lequel l'intervalle d'échantillonnage de courant est essentiellement égal à 240 µs et le nombre prédéterminé d'échantillons de courant est situé dans la plage de 1 à 4.

6. Commutateur selon l'une quelconque des revendications précédentes, comprenant en outre un dispositif de surveillance de courant moyen pour surveiller le courant moyen à travers la paire de transistors de sortie et qui est agencé, lorsqu'il fonctionne, de façon à échantillonner le courant moyen à des intervalles d'échantillonnage de courant moyen et, dans le cas où le courant dépasse un seuil prédéterminé de courant moyen pour plus qu'un nombre prédéterminé de cycles c.a., une condition de surcharge est détectée.

7. Commutateur selon la revendication 6, dans lequel l'intervalle d'échantillonnage de courant moyen est essentiellement égal à 300 ms et le nombre prédéterminé de cycles c.a. est 3.
